# EUROPEAN PATENT APPLICATION

(11) **EP 4 694 664 A2**
(43) Date of publication of application: **11.02.2026**
(21) Application number: 25192603.6
(22) Date of filing: 29.07.2025
(51) Int. Cl.: H10P 72/30

(54) **CONTAINER TRANSFER METHOD, SUBSTRATE PROCESSING METHOD, METHOD OF MANUFACTURING SEMICONDUCTOR DEVICE, PROGRAM AND SUBSTRATE PROCESSING APPARATUS**

(30) Priority: 30.07.2024 JP 2024123710
(71) Applicant: Kokusai Electric Corp., Tokyo 1010045 (JP)
(72) Inventor: TANIKAWA, Risa, Toyama-shi, 939-2393 (JP)
(74) Representative: Verscht, Thomas Kurt Albert

(57) **Abstract**

It is possible to increase a transfer throughput of the substrate. There is provided a technique that includes: (a) supporting a container capable of accommodating a substrate with a first container support; and (b) controlling a rotating shaft for revolving placement structures arranged in a circumferential direction, an elevating structure for elevating a transfer robot and the transfer robot such that, when transferring a container from the transfer robot to a predetermined placement structure, a second moving speed of the elevating structure at which the transfer robot is elevated is faster than a first moving speed at which the predetermined placement structure is moved to a transfer position where the container is transferable from the transfer robot.

## Description

### [Technical Field]

The present disclosure relates to a container transfer method, a substrate processing method, a method of manufacturing a semiconductor device, a program and a substrate processing apparatus.

### [Related Art]

As a substrate processing apparatus, for example, a substrate processing apparatus Patent Document 1 is known.

### [Related Art Document]

### [Patent document]

Patent Document 1: Japanese Patent Laid-Open No. 2020-161804

### [Disclosure]

### [Technical Problem]

In the substrate processing apparatus (see Patent Document 1, for example), a container capable of storing a substrate is transferred from a loading port structure to a placement structure of a rotatable storage shelf. However, in such a substrate processing apparatus, there is room for improvement in terms of increasing a transfer throughput for the substrate.

According to the present disclosure, there is provided a technique capable of increasing the transfer throughput for the substrate.

### [Technical Solution]

According to an embodiment of the present disclosure, there is provided a technique that includes: (a) supporting a container capable of accommodating a substrate with a first container support; and (b) controlling: a rotating shaft capable of revolving a plurality of placement structures of a second container support, wherein the plurality of placement structures are capable of supporting the container, and the second container support is arranged above the first container support and provided with the plurality of placement structures arranged in a circumferential direction; an elevating structure capable of elevating and lowering a transfer robot along an elevating shaft; and the transfer robot capable of transferring the container to and from the first container support or the second container support, wherein the rotating shaft, the elevating structure and the transfer robot is controlled such that, when transferring the container from the transfer robot to a predetermined placement structure among the plurality of placement structures, a second moving speed of the elevating structure at which the transfer robot is elevated along the elevating shaft is faster than a first moving speed at which the predetermined placement structure is moved to a transfer position where the container is transferable from the transfer robot.

### [Advantageous Effects]

According to some embodiments of the present disclosure, it is possible to increase a transfer throughput for a substrate.

### [Brief Description of Drawings]

FIG. 1 is a diagram schematically illustrating a perspective view of an overall configuration of a substrate processing apparatus preferably used in one or more embodiments of the present disclosure.
FIG. 2 is a diagram schematically illustrating a vertical cross-section of the substrate processing apparatus preferably used in the embodiments of the present disclosure.
FIG. 3 is a diagram schematically illustrating a horizontal cross-section of the substrate processing apparatus preferably used in the embodiments of the present disclosure.
FIG. 4 is a block diagram schematically illustrating a configuration of a controller preferably used in the substrate processing apparatus preferably used in the embodiments of the present disclosure.
FIG. 5 is a block diagram schematically illustrating a configuration of a subsidiary controller preferably used in the substrate processing apparatus preferably used in the embodiments of the present disclosure.
FIG. 6A is a diagram schematically illustrating an operation of a transfer robot in the substrate processing apparatus preferably used in the embodiments of the present disclosure, wherein a state before a container supported by the transfer robot is placed on a shelf plate is illustrated.
FIG. 6B is a diagram schematically illustrating an operation of the transfer robot shown in FIG. 6A, wherein a state in which the container supported by the transfer robot is placed on the shelf plate is illustrated.
FIG. 6C is a diagram schematically illustrating an operation of the transfer robot shown in FIG. 6A, wherein a state after the container is placed on the shelf plate by the transfer robot is illustrated.
FIG. 7 is a flow chart schematically illustrating a container transfer sequence in a substrate processing apparatus according to a comparative example.
FIG. 8 is a flow chart schematically illustrating a container transfer sequence in the substrate processing apparatus preferably used in the embodiments of the present disclosure.

### [Detailed Description]

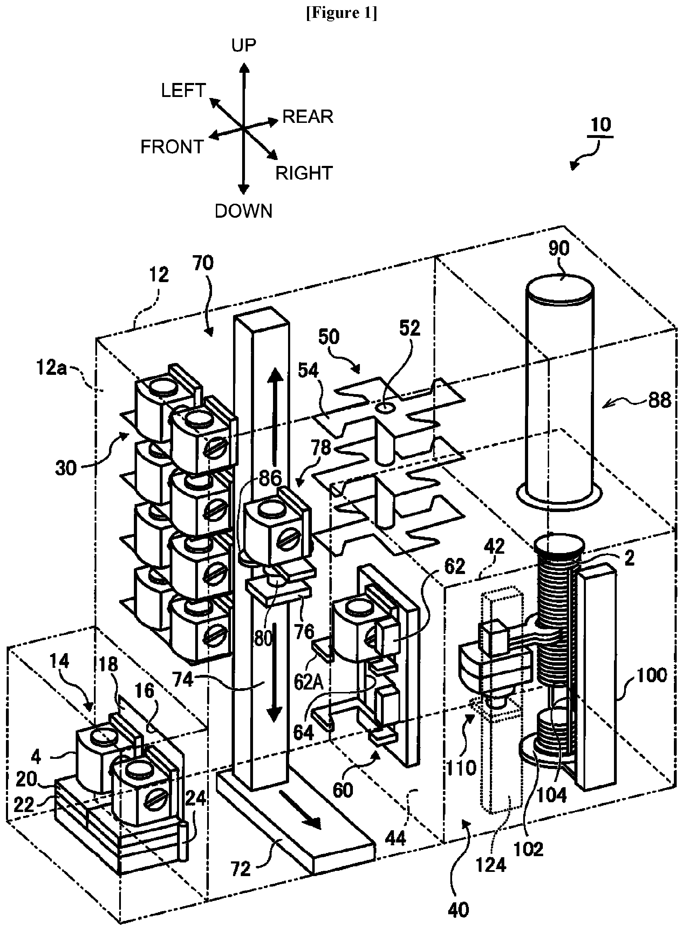

A substrate processing apparatus 10 preferably used in one or more embodiments (also simply referred to as "embodiments") according to the technique of the present disclosure will be described with reference to FIGS. 1 to 8.

The drawings used in the following description are all schematic. For example, a relationship between dimensions of each component and a ratio of each component shown in the drawing may not always match the actual ones. Further, for example, even between the drawings, the relationship between the dimensions of each component and the ratio of each component may not always match. In addition, in the following description, like reference numerals represent like components in the drawings, and redundant descriptions related thereto may be omitted.

In the present specification, the term "wafer" may refer to "a wafer itself", or may refer to "a wafer and a stacked structure (aggregated structure) of a predetermined layer (or layers) or a film (or films) formed on a surface of the wafer". That is, the term "wafer" may collectively refer to "a wafer and a layer (layers) or a film (films) formed on a surface of the wafer". In addition, in the present specification, the term "a surface of a wafer" may refer to "a surface of a wafer itself (exposed surface)", or may refer to "a surface of a predetermined layer (or a predetermined film) formed on a wafer, which is a top surface of the wafer as a stacked structure".

In the present specification, the terms "substrate" and "wafer" may be used as substantially the same meaning.

For example, the substrate processing apparatus 10 according to the present embodiments is configured as a semiconductor manufacturing apparatus capable of performing a processing serving as a part of a method of manufacturing a semiconductor device such as an IC (integrated circuit). In the following description, the present embodiments will be described by way of an example in which a batch type vertical semiconductor manufacturing apparatus (hereinafter, also simply referred to as a "processing apparatus") capable of performing a process such as an oxidation process, a diffusion process and a CVD (chemical vapor deposition) process is used as the substrate processing apparatus 10. In addition, a front-rear direction, a left-right direction and an up-down direction (vertical direction) of the substrate processing apparatus 10 according to the present embodiments are as shown in FIG. 1.

### <Container (FOUP) 4>

As shown in FIGS. 1 to 3, in the substrate processing apparatus 10 according to the present embodiments, a container 4 (which may also be referred to as a FOUP (Front Opening Unified Pod)) is used. The container 4 serves as a substrate container (wafer carrier) configured to accommodate a wafer 2 serving as a substrate. For example, the wafer 2 is made of silicon (Si).

### <Loading/unloading Structure (Loading Port Structure) 14>

The substrate processing apparatus 10 includes a substrate processing apparatus main structure (also referred to as a "substrate processing apparatus body") 12. A loading/unloading structure (which is a loading port structure) 14 is provided on a front wall 12a of the substrate processing apparatus main structure 12 such that the container 4 can be transferred (loaded) into and transferred (unloaded) out of the substrate processing apparatus main structure 12. The front wall 12a is provided with a loading/unloading port 16 through which an inside (inner portion) and an outside (outer portion) of the substrate processing apparatus main structure 12 are in communication with each other. The loading/unloading port 16 is configured to be opened and closed by an opening/closing structure 18.

The loading/unloading structure 14 is constituted by: a placement structure 20 serving as an example of a first container support (which is a first container support structure) on which the container 4 is placed; a transfer structure 22 configured to transfer (slide) the placement structure 20 in the front-rear direction; and a rotator (which is a rotating structure) 24 configured to be capable of rotating the placement structure 20 and the transfer structure 22. For example, the rotating structure 24 is constituted by a component such as a hinge. According to the present embodiments, two placement structures including the placement structure 20 and two transfer structures including the transfer structure 22 are provided side by side in the left-right direction. Hereinafter, each of the two placement structures including the placement structure 20 may also be referred to as the "placement structure 20", and each of the two transfer structures including the transfer structure 22 may also be referred to as the "transfer structure 22".

When the transfer structure 22 transfers the placement structure 20 in the front-rear direction, the container 4 placed on the placement structure 20 is transferred between the inside and the outside of the substrate processing apparatus main structure 12 through the loading/unloading port 16. In a manner described above, the transfer structure 22 transfers the placement structure 20 between a loading/unloading position and a delivery position. The loading/unloading position refers to a position outside the substrate processing apparatus main structure 12 where the container 4 is transferred from or to an external transfer apparatus (which is an external transfer structure) (not shown). In addition, the delivery position refers to a position inside the substrate processing apparatus main structure 12 where the container 4 is transferred from or to a container transfer apparatus (which is a container transfer structure or a pod transfer structure) 70 described later.

For example, the placement structure 20 and the transfer structure 22 are rotated forward when a maintenance operation for the substrate processing apparatus main structure 12 is performed.

### <Buffer Shelf 30>

A buffer shelf 30 is provided inside the substrate processing apparatus main structure 12 at a location above and behind the loading/unloading structure 14. The buffer shelf 30 serves as a first storage capable of storing a plurality of containers including the container 4. Hereinafter, the plurality of containers including the container 4 may also be simply referred to as "containers 4".

The buffer shelf 30 is constituted by: a support plate 32 attached to an inner surface of the front wall 12a; and a plurality of shelf plates 34 supported horizontally by the support plate 32. Hereinafter, each of the plurality of shelf plates 34 may also be simply referred to as a "shelf plate 34". The buffer shelf 30 is configured such that the containers 4 are arranged and placed on the shelf plates 34, respectively, in the left-right arrangement.

A sub-housing 40 is provided at a rear lower portion of the substrate processing apparatus main structure 12. The sub-housing 40 forms a space fluidically isolated from a space inside the substrate processing apparatus main structure 12 by a horizontal wall 42 provided in the front-rear direction and a vertical wall 44 provided in the up-down direction.

### <Rotatable Shelf 50>

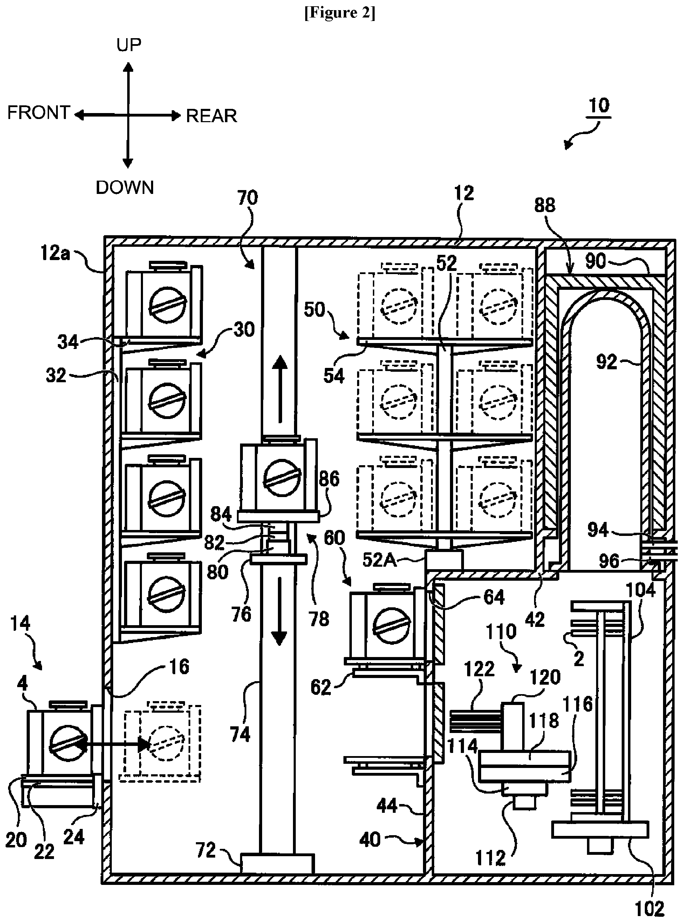

As shown in FIGS. 1 and 2, a rotatable shelf 50 on which the containers 4 can be placed is provided above the sub-housing 40.

The rotatable shelf 50 is provided vertically. The rotatable shelf 50 includes: a rotating shaft 52; a plurality of shelf plates 54 serving as a second container support (which is a second container support structure) radially supported on the rotating shaft 52; and a support column rotator (which is a support column rotating structure) 52A configured to drive the rotating shaft 52 to rotate intermittently.

The support column rotator 52A includes a CR axis motor (not shown) serving as a CR driver (which is a CR driving structure) configured to drive the rotating shaft 52 to rotate. A CR axis encoder (not shown) is connected to the CR axis motor. The CR axis encoder serves as a sensor configured to detect a rotation direction, a rotation position and a rotation speed of the CR axis motor.

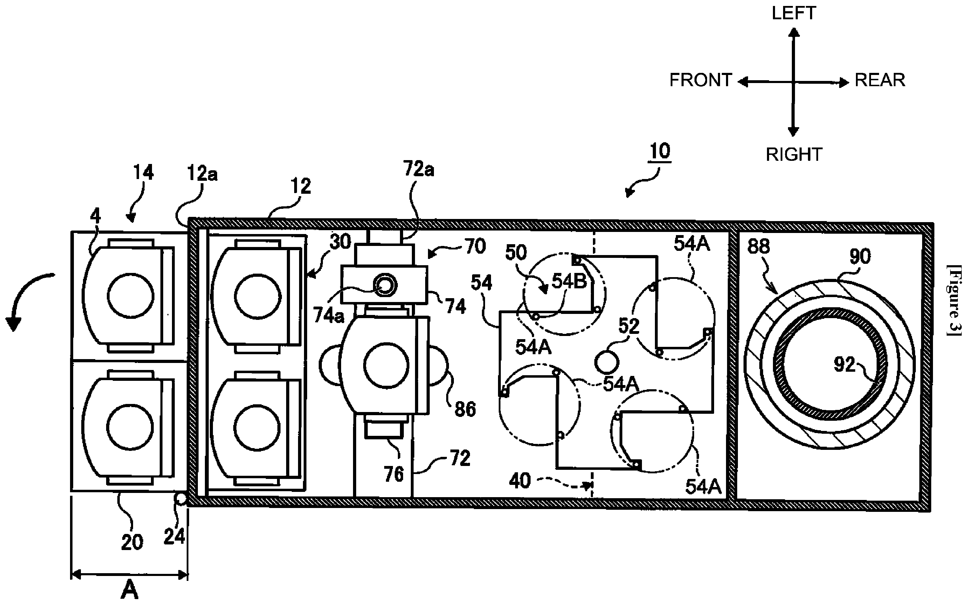

The shelf plate 54 includes: a plurality of convex structures which are radially arranged; a base (which is a base structure) provided in the vicinity of a central portion of the shelf plate 54 to which the plurality of convex structures are connected. More specifically, the shelf plate 54 is formed in a Swastika shape by combining four hook structures. As shown in FIG. 3, four placement structures 54A are provided at front ends (tips) of four hook structures of the shelf plate 54. That is, the four placement structures 54A are provided on the shelf plate 54. Hereinafter, each of four placement structures 54A may also be simply referred to as a "placement structure 54A". The placement structure 54A is constituted by a portion surrounded by a dash-double dotted line including a space provided between adjacent convex structures and a part of a configuration of the adjacent convex structures. The placement structures 54A are provided in a circumferential direction around the rotating shaft 52.

On an upper surface of each of the four placement structures 54A of the shelf plate 54, pins 54B (which serve as protrusions) protrude at three locations. By engaging a concave structure (not shown) of the container 4 with the pins 54B of the placement structure 54A, the container 4 is positioned at a predetermined position (on the placement structure 54A).

When transferring the container 4 from a hand 86 of a transfer robot 78 described later to the shelf plate 54, the hand 86 is moved downward from a location slightly higher than the shelf plate 54 to place the container 4 on the placement structure 54A. For example, a groove of a V shape (not shown) is formed (formed) in the concave structure of the container 4, and when the pins 54B fit into the groove of the V shape due to a relative movement between the container 4 and the shelf plate 54 (in a direction of rotation of the shelf plate 54), the container 4 is locked.

### <Container Opening/Closing Apparatus (Pod Opener)>

As shown in FGIS. 1 and 2, for example, in the vertical wall 44 of the sub-housing 40, two wafer loading port structures 60 configured to transfer the wafer 2 to/from the container 4 from/into the sub-housing 40 (that is, to load or unload the wafer 2) are provided in the up-down direction. Hereinafter, each of the wafer loading port structures 60 may also be referred to as a "wafer loading port structure 60". The wafer loading port structure 60 is provided with a container opening/closing apparatus (which is a container opening/closing structure) 62 configured to open and close the container 4 by attaching and detaching a lid of the container 4. That is, for example, two container opening/closing apparatuses are provided in the up-down direction. Hereinafter, an upper one of the two container opening/closing apparatuses may also be referred to as an "upper container opening/closing apparatus 62" and a lower one of the two container opening/closing apparatuses may also be referred to as a "lower container opening/closing apparatus 62". In addition, the vertical wall 44 is provided with a loading/unloading port 64 corresponding to the wafer loading port structure 60. The wafer 2 is transferred between an inside (inner portion) and an outside (outer portion) of the sub-housing 40 through the loading/unloading port 64. The container opening/closing apparatus 62 includes: a placement table (mounting table) 62A serving as an example of the first container support on which the container 4 is placed; and a cap attaching/detaching structure (not shown) configured to attach and detach a cap (lid) of the container 4. The container opening/closing apparatus 62 is configured to open and close a wafer entrance of the container 4 by attaching and detaching the cap of the container 4 placed on the placement table 62A using the cap attaching/detaching structure.

### <Container Transfer Apparatus 70>

The container transfer apparatus 70 configured to transfer the container 4 is provided between the buffer shelf 30 and the rotatable shelf 50 inside the substrate processing apparatus main structure 12. The container transfer apparatus 70 is configured to transfer the container 4 among the placement structure 20, the buffer shelf 30, the rotatable shelf 50 and the wafer loading port structure 60.

The container transfer apparatus 70 is constituted by: a linear actuator 72 provided in the left-right direction on a bottom surface of the substrate processing apparatus main structure 12; and an elevator 74 provided upright (vertically) on an upper portion of the linear actuator 72. The elevator 74 serves as an example of an elevating structure capable of elevating and lowering an elevating platform (elevating table) 76 along an elevating shaft of the present disclosure.

The linear actuator 72 is configured to move the elevator 74 in the left-right direction using a motor 72a as a drive source. The elevator 74 is configured to elevate and lower the elevating platform 76 provided on the elevator 74 using a motor (not shown) as a drive source.

On the elevating platform 76, the transfer robot 78 is provided. The transfer robot 78 is configured to support (or hold) the container 4 placed at a predetermined position and to place (handle) the container 4 at another predetermined position.

For example, as the transfer robot 78, a SCARA (Selective compliance assembly robot arm) type robot (a horizontal multi-joint robot) may be used. Specifically, the transfer robot 78 is provided with a rotary actuator 80 installed vertically on the elevating platform 76. The rotary actuator 80 is configured to rotate a first arm 82 in a horizontal plane, wherein one end (first end) of the first arm 82 is fixed to a rotating shaft serving as an output shaft of the rotary actuator 80.

One end (first end) of a second arm 84 is axially supported on the other end (second end) of the first arm 82, and the second arm 84 is configured to be rotated in a horizontal plane by the rotary actuator 80. The hand 86 configured to support (hold) the container 4 is attached horizontally to the other end (second end) of the second arm 84, and the hand 86 is further configured to pick up the container 4 from thereunder and support the container 4 horizontally. In addition, by axially supporting the one end of the second arm 84 on the other end of the first arm 82, it is possible to provide a robot arm capable of supporting the container 4 using the first arm 82 and the second arm 84. With such a configuration described above, it is possible to move the hand 86 in the up-down direction, the front-rear direction and the left-right directions of an apparatus (that is, the substrate processing apparatus 10), that is, it is possible to perform a three dimensional operation of the hand 86.

### <Process Chamber (Process Tube) 92>

A processing structure 88 for the wafer 2 is provided at the rear upper portion of the substrate processing apparatus main structure 12, and a heater 90 is installed upright (vertically) in the processing structure 88. Inside the heater 90, a process chamber (process tube) 92 in which the wafer 2 is processed is arranged (provided) in a manner concentric with the heater 90. A gas introduction pipe 94 through which a gas such as a process gas and a purge gas is introduced into the process chamber 92 and an exhaust pipe 96 through which an atmosphere (inner atmosphere) of the process chamber 92 is exhausted are connected to the process chamber 92.

A boat elevating apparatus (boat elevator) 100 is provided below the heater 90 and within the sub-housing 40. The boat elevating apparatus 100 is configured to vertically elevate and lower a cap 102 horizontally arranged directly below the process chamber 92. The cap 102 is of a disk shape whose diameter is larger than that of a lower end opening of the process chamber 92. The cap 102 is configured to seal the lower end opening of the process chamber 92 and to support a boat 104 in a vertically standing state.

The boat 104 is configured to support the wafers 2 arranged horizontally with their centers aligned with one another. As the cap 102 is elevated or lowered by the boat elevating apparatus 100, the boat 104 is configured to be loaded into or unloaded out of the process chamber 92. The boat 104 is configured to accommodate a large number of the wafers 2 (for example, 100 wafers to 150 wafers) as compared with the number of the wafers 2 (for example, 25 wafers) accommodated in the container 4 alone. In the process chamber 92, the wafer 2 is capable of being processed with a predetermined gas.

### <Wafer Transfer Apparatus 110>

A wafer transfer apparatus (which is a wafer transfer structure) 110 is provided in a space inside the sub-housing 40. The wafer transfer apparatus 110 is configured to transfer the wafer 2 between the wafer loading port structure 60 and the boat 104.

The wafer transfer apparatus 110 includes a base (which is a base structure) 112. A rotary actuator 114 is provided on an upper surface of the base 112, and a first linear actuator 116 is provided on an upper portion of the rotary actuator 114. The rotary actuator 114 is configured to rotate the first linear actuator 116 in a horizontal plane.

A second linear actuator 118 is provided on an upper portion of the first linear actuator 116. The first linear actuator 116 is configured to move the second linear actuator 118 horizontally. A mounting base 120 is provided on an upper portion of the second linear actuator 118. The second linear actuator 118 is configured to move the mounting base 120 horizontally. A plurality of tweezers 122 configured to support the wafers 2 from thereunder are attached horizontally at an equal interval to the mounting base 120.

The wafer transfer apparatus 110 is configured to be elevated and lowered by an elevator 124.

### <Controller 240>

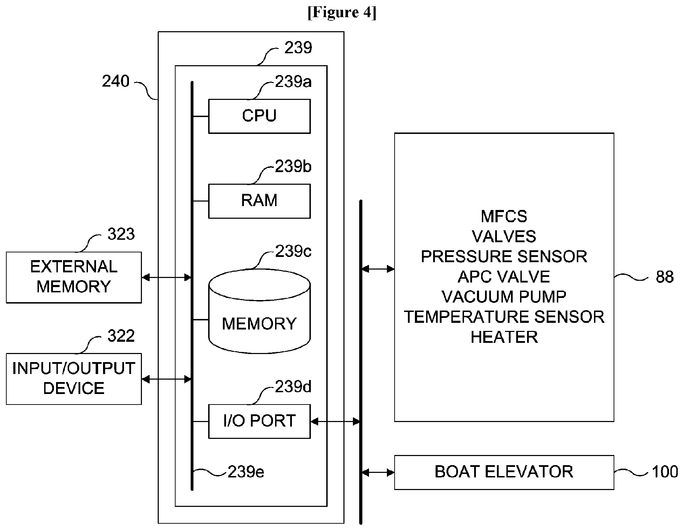

A controller 240 serving as a control structure of controlling operations of components constituting the substrate processing apparatus 10 according to the present embodiments will be described with reference to FIGS. 3 and 4.

For example, the controller 240 including a main controller (primary controller) 239 is configured to control the components constituting the substrate processing apparatus 10 to perform various operations such as a temperature adjusting operation of the heater 90, an elevating and lowering operation of the boat elevating apparatus 100, a flow rate adjusting operation of an MFC (not shown) connected to the process chamber 92, an opening and closing operation of a valve (not shown), an opening and closing operation of an APC (Automatic Pressure Controller) valve (not shown), a start and stop of a vacuum pump (not shown), and an operation of adjusting a rotational speed of the rotating shaft 52 of the rotatable shelf 50.

The main controller 239 is constituted by a computer including a CPU (Central Processing Unit) 239a, a RAM (Random Access Memory) 239b, a memory 239c and an I/O port (input/output port) 239d. The RAM 239b, the memory 239c and the I/O port 239d are configured to be capable of exchanging data with the CPU 239a via an internal bus 239e. For example, an input/output device 322 constituted by a component such as a touch panel is connected to the main controller 239.

For example, the memory 239c is configured by a component such as a flash memory and a hard disk drive (HDD). For example, a control program configured to control an operation of the substrate processing apparatus 10, a transfer sequence in which transfer procedures for the container 4 is contained, and a process recipe containing information on procedures and conditions of a substrate processing described later may be readably stored in the memory 239c. The transfer sequence or the process recipe is obtained by combining steps (procedures) of the substrate processing described later such that the controller 240 can execute the steps to acquire a predetermined result, and functions as a program. Hereinafter, the process recipe and the control program may be collectively or individually referred to as a "program" or a "program product". Thus, in the present specification, the term "program" may refer to the process recipe alone, may refer to the control program alone or may refer to both of the process recipe and the control program. The RAM 239b functions as a memory area (work area) where a program or data read by the CPU 239a is temporarily stored.

The I/O port 239d is further connected to various transfer apparatuses (which are transfer structures) in the apparatus via a drive controller 237.

The CPU 239a is configured to read the control program from the memory 239c and execute the control program read from the memory 239c. In addition, the CPU 239a is configured to read the process recipe from the memory 239c, for example, in accordance with an operation command inputted from the input/output device 322. In accordance with contents of the process recipe read from the memory 239c, the CPU 239a is configured to be capable of controlling various operations such as operations of the various transfer apparatuses.

For example, the controller 240 is not limited to a dedicated computer, and may be embodied by a general-purpose computer. For example, the controller 240 according to the present embodiments may be embodied by preparing an external memory 323 storing the program and by installing the program onto the general-purpose computer using the external memory 323. For example, the external memory 323 may include a magnetic tape, a magnetic disk such as a flexible disk and a hard disk, an optical disk such as a CD and a DVD and a semiconductor memory such as a USB memory and a memory card. However, a method of providing the program to the computer is not limited to that using the external memory 323. For example, the program may be supplied to the computer (general-purpose computer) using a communication interface such as the Internet and a dedicated line without using the external memory 323. The memory 239c or the external memory 323 may be embodied by a non-transitory computer readable recording medium. Hereafter, the memory 239c and the external memory 323 may be collectively or individually referred to as a "recording medium". Thus, in the present specification, the term "recording medium" may refer to the memory 239c alone, may refer to the external memory 323 alone, or may refer to both of the memory 239c and the external memory 323.

In addition, the program can cause the substrate processing apparatus 10, by using the computer, to perform: when transferring the container 4 from the transfer robot 78 to the placement structure 54A (which is predetermined as a destination), rotating the shelf plate 54 to move the placement structure 54A at a first moving speed V1 and elevating the transfer robot 78 by the elevator 74 at a second moving speed V2 faster than the first moving speed V1 such that the placement structure 54A is moved to a position at which the container 4 can be transferred (received) from the transfer robot 78.

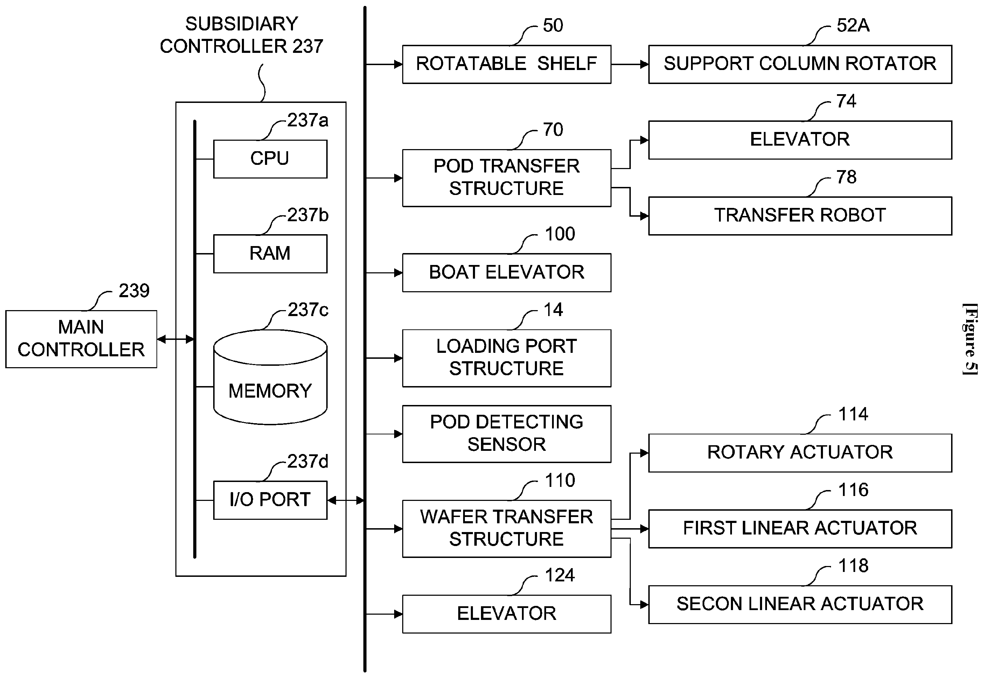

FIG. 5 is a block diagram schematically illustrating exemplary functional blocks for controlling each of the transfer structures by the drive controller 237 (which is one of subsidiary controllers). As shown in FIG. 5, the drive controller 237 is configured to be capable of controlling each transfer structure including the container transfer apparatus 70, the boat elevating apparatus 100, the wafer transfer apparatus 110, the rotatable shelf 50 and the like. The drive controller 237 is further configured to acquire data from sensors (not shown) attached to each transfer structure. According the present embodiments, since a configuration of the drive controller 237 is substantially the same as that of the controller 240, a description thereof will be omitted.

When the container 4 (which is transferred from outside the apparatus) is placed on the placement structure 20, a signal is transmitted from a container presence/absence sensor (which is a container detecting sensor) to the drive controller 237. The container presence/absence sensor may also be referred to as a "pod presence/absence sensor" or a as a "pod detecting sensor". In addition, the drive controller 237 is further configured to drive the container transfer apparatus 70 to transfer the container 4 to one of the placement structures 54A of the rotatable shelf 50 in accordance with a type of the wafer 2 stored in the container 4.

In addition, the drive controller 237 is further configured to perform a transfer sequence of transferring the container 4 between the rotatable shelf 50 and the container transfer apparatus 70. Thus, the rotatable shelf 50 is configured to rotate the shelf plate 54 by the drive controller 237, and is further configured to transfer the container 4 between the container transfer apparatus 70 and the rotatable shelf 50.

### <Description of Operation of Substrate Processing Apparatus 10>

Subsequently, the operation of the substrate processing apparatus 10 according to the present embodiments will be described. As shown in FIGS. 1 and 2, when the container 4 is transferred to the loading/unloading structure 14, the loading/unloading port 16 is opened by the opening/closing structure 18, and the container 4 on the placement structure 20 is loaded into the substrate processing apparatus main structure 12 through the loading/unloading port 16 by the container transfer apparatus 70.

The container 4 loaded into the substrate processing apparatus main structure 12 is then automatically transferred to and placed on the placement structure 54A of the shelf plate 54 (which is designated) of the rotatable shelf 50 by the container transfer apparatus 70, then temporarily stored on the shelf plate 54, then transferred from the shelf plate 54 to one of the upper container opening/closing apparatus 62 and the lower container opening/closing apparatus 62, and then transferred to the placement table 62A of the wafer loading port structure 60. Alternatively, the container 4 loaded into the substrate processing apparatus main structure 12 is automatically transferred and placed on the shelf plate 34 (which is designated) of the buffer shelf 30 by the container transfer apparatus 70, then temporarily stored on the shelf plate 34, then transferred from the shelf plate 34 to one of the upper container opening/closing apparatus 62 and the lower container opening/closing apparatus 62, and then transferred to the placement table 62A of the wafer loading port structure 60. Alternatively, the container 4 loaded into the substrate processing apparatus main structure 12 is directly transferred to the container opening/closing apparatus 62, and then transferred to the placement table 62A.

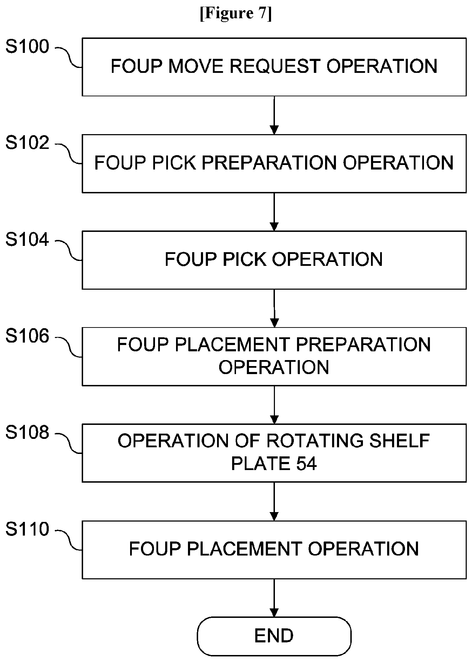

Hereinafter, a transfer operation of the container 4 in a substrate processing apparatus according to a comparative example will be described based on a flow chart shown in FIG. 7. In addition, a configuration of the substrate processing apparatus according to the comparative example is substantially the same as that of the substrate processing apparatus 10 according to the present embodiments. However, the transfer operation of the container 4 according to the comparative example is different from a transfer operation of the container 4 in the substrate processing apparatus 10 according to the present embodiment which will be described later. In the following description, the controller 240 controls operations of the components such as the transfer robot 78.
(1) First, a step S100 is a container move request operation ("FOUP MOVE REQUEST OPERATION" in FIG. 7). In the step S100, the controller 240 requests for a movement of the container 4. In other words, the controller 240 instructs the components such as the transfer robot 78 to move the container 4.
(2) A step S102 is a container pick preparation operation ("FOUP PICK PREPARATION OPERATION" in FIG. 7). In the step S102, the transfer robot 78 is moved to a height of the container 4 such that the robot arm of the transfer robot 78 can pick up the container 4 on the placement structure 20.
(3) A step S104 is a container pick operation ("FOUP PICK OPERATION" in FIG. 7). In the step S104, the robot arm of the transfer robot 78 picks up the container 4. That is, the robot arm of the transfer robot 78 picks up the container 4 placed on the placement structure 20.
(4) A step S106 is a container placement preparation operation ("FOUP PLACEMENT PREPARATION OPERATION" in FIG. 7). In the step S106, the transfer robot 78 that picked up the container 4 is elevated to a height of the shelf plate 54 (which is predetermined) of the rotatable shelf 50 (that is, a transfer position (delivery position) for the container 4), and is prepared for the transfer operation.
(5) A step S108 is an operation of rotating the shelf plate 54 ("OPERATION OF ROTATING SHELF PLATE 54" in FIG. 7). After the container 4 is elevated to the height of the shelf plate 54 in the step 106, in the step S108, the shelf plate 54 is rotated such that the placement structure 54A (which is predetermined) where the container 4 is to be placed is located to face the container 4.
(6) A step S110 is a container placement operation ("FOUP PLACEMENT OPERATION" in FIG. 7). In the step S110, the robot arm is extended, and the container 4 is placed on the placement structure 54A where the container 4 is to be placed.

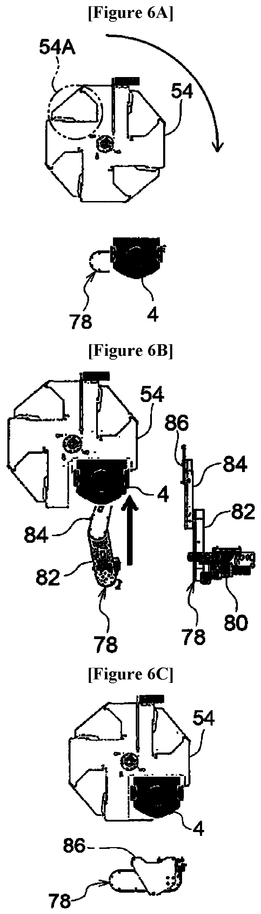

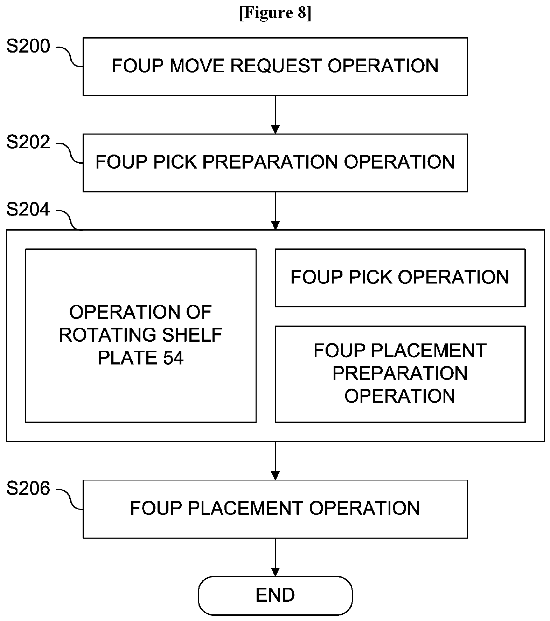

Subsequently, the transfer operation of the container 4 in the substrate processing apparatus 10 according to the present embodiments will be described based on a flow chart shown in FIG. 8.
(1) First, a step S200 is a container move request operation ("FOUP MOVE REQUEST OPERATION" in FIG. 8). In the step S200, the controller 240 requests for the movement of the container 4. In other words, the controller 240 instructs the components such as the transfer robot 78 to move the container 4.
(2) A step S202 is a container pick preparation operation ("FOUP PICK PREPARATION OPERATION" in FIG. 8). In the step S202, the transfer robot 78 is moved to the height of the container 4 such that the robot arm of the transfer robot 78 can pick up the container 4 on the placement structure 20.
(3) In a step 204, a container pick operation ("FOUP PICK OPERATION" in FIG. 8), a container placement preparation operation ("FOUP PLACEMENT PREPARATION OPERATION" in FIG. 8) and an operation of rotating the shelf plate 54 ("OPERATION OF ROTATING SHELF PLATE 54" in FIG. 8) are performed in parallel. The term "performed in parallel" may also refer to a case where an operation of the container transfer apparatus 70 and an operation of the rotatable shelf 50 are performed partially in parallel. In the step 204, the container 4 placed on the placement structure 20 is picked up by the robot arm, and then is elevated to the height of the shelf plate 54 (which is predetermined) of the rotatable shelf 50 (that is, the transfer position for the container 4). In parallel with such an operation, as shown in FIG. 6A, the shelf plate 54 is rotated such that the placement structure 54A (which is predetermined) on which the container 4 is to be placed is located to face the container 4 picked up by the hand 86, that is, located at the transfer position for the container 4. Thereby, it is possible for the transfer robot 78 to transfer the container 4 without waiting at the transfer position for the container 4.
(4) A step S206 is a container placement operation ("FOUP PLACEMENT OPERATION" in FIG. 8). In the step S206, as shown in FIG. 6B, the container 4 is placed on the placement structure 54A (which is predetermined) at the transfer position for the container 4. Then, as shown in FIG. 6C, the robot arm is returned from an extended state to an original state thereof.

In addition, according to the present embodiments, when transferring the container 4 from the transfer robot 78 to the placement structure 54A (which is predetermined), the controller 240 can perform a control (control operation) such that the second moving speed V2 at which the elevator 74 elevates the transfer robot 78 is set to be faster than the first moving speed V1 (that is, a moving speed of the placement structure 54A when the placement structure 54A is moved around the rotating shaft 52) at which the rotating shaft 52 revolves such that the placement structure 54A is moved to the position at which the container 4 can be transferred from the transfer robot 78.

The first moving speed V1 may be set to a speed at which the placement structure 54A (which is predetermined) can be moved to reach the position at which the container 4 can be transferred during a time in which the transfer robot 78 is moved from a position at which an operation of picking up the container 4 from the placement structure 20 of the loading/unloading structure 14 is performed (that is, a position at which the container pick operation ("FOUP PICK OPERATION" in FIG. 8) is performed) to reach a height position of the placement structure 54A.

In addition, when another container among the containers 4 is already placed on the shelf plate 54, the first moving speed V1 may be set to a speed at which the container 4 placed on the placement structure 20 of the loading/unloading structure 14 can be transferred onto the shelf plate 54 while supporting the another container (among the containers 4) on the shelf plate 54. Thereby, it is possible to increase a transfer throughput.

By the way, when rotating the shelf plate 54 with the container 4 placed on the placement structure 54A of the shelf plate 54, there is a limit to a rotation speed of the shelf plate 54. In other words, when the rotation speed of the shelf plate 54 is too fast, there is a concern that the wafer 2 supported within the container 4 may shift. In such a case, the wafer 2 may collide with a wall (for example, the lid) of the container 4, and as a result, a damage or peeling of a film formed on the wafer 2 may occur, and particles may be generated in the container 4 due to the peeling. In addition, when the rotation speed of the shelf plate 54 becomes faster and thereby a centrifugal force acting on the container 4 becomes larger, there is a concern that a supporting state (holding state) of the container 4 may become unstable due to the centrifugal force. Therefore, it is preferable to set the first moving speed V1 as fast as possible so as to prevent the supporting state of the container 4 from becoming unstable or to prevent a malfunction of the container 4.

On the other hand, since an elevating and lowering movement of the transfer robot 78 is a linear movement, it is possible to set the second moving speed V2 of the elevator 74 to be faster than the first moving speed V1. As a result, by rotating the shelf plate 54 such that the placement structure 54A is moved at the first moving speed V1 while elevating the container 4 at the second moving speed V2 faster than the first moving speed V1, it is possible to increase the transfer throughput while supporting the container 4 on the shelf plate 54. In other words, by setting the first moving speed V1 to be lower than the second moving speed V2, it is possible for the transfer robot 78 to transfer the container 4 picked up from the placement structure 20 to the transfer position for the container 4 during a time in which the placement structure 54A (which is predetermined as the destination) of the shelf plate 54 is rotated to reach the transfer position for the container 4 to be transferred from the transfer robot 78. Thereby, it is possible to increase the transfer throughput.

In addition, the rotating operation of the shelf plate 54 may be performed prior to an operation of the transfer robot 78. By performing the rotating operation of the shelf plate 54 in advance by utilizing a time in which the transfer robot 78 picks up the container 4 placed on the placement structure 20 of the loading/unloading structure 14, it is possible to contribute to improving a throughput (that is, the transfer throughput).

### <Processing of Wafer 2>

According to the present embodiments, the container 4 transferred from the placement structure 20 of the loading/unloading structure 14 to the placement structure 54A of the shelf plate 54 of the rotatable shelf 50 (or the container 4 placed on the buffer shelf 30 from the placement structure 20) can be transferred by the transfer robot 78 of the container transfer apparatus 70 to the placement table 62A of the container opening/closing apparatus 62.

In the substrate processing apparatus 10 according to the present embodiments, the container 4 placed on the placement structure 20 of the loading/unloading structure 14 may be transferred to the placement table 62A of the container opening/closing apparatus 62 by the container transfer apparatus 70, the container 4 may be transferred from the rotatable shelf 50 to the placement table 62A by the container transfer apparatus 70, or the container 4 may be transferred from the buffer shelf 30 to the placement table 62A by the container transfer apparatus 70.

The wafer entrance of the container 4 placed on the placement table 62A of the container opening/closing apparatus 62 is opened by the cap attaching/detaching structure. The wafers 2 in the container 4 are then transferred to the boat 104 by the tweezers 122 of the wafer transfer apparatus 110. The boat 104 accommodating the wafers 2 is transferred into the process chamber 92, where the wafers 2 can be processed with the predetermined gas. In addition, a processing of the wafer 2 (that is, the substrate processing mentioned above) in the process chamber 92 is performed, for example, by supplying the process gas through the gas introduction pipe 94 to the process chamber 92 to process the film formed on the wafer 2, while exhausting the inner atmosphere of the process chamber 92 through the exhaust pipe 96. In a manner described above, a process such as a film forming process is performed on the wafer 2.

### <Supplementary Description of Present Embodiments>

When the controller 240 determines that the transfer operation of the container 4 to the shelf plate 54 to which the container 4 is to be transferred is "not proper", the controller 240 can perform a control such that the transfer operation of the container 4 is not performed.

In addition, for example, when a distance from a front end (tip) of the second arm 84 of the transfer robot 78 to the placement structures 54A is not equal to a predetermined distance (for example, when the distance is longer or shorter than the predetermined distance), the controller 240 can control the transfer robot 78 not to move the container 4 to the placement structures 54A, or can control an alarm apparatus (not shown) to issue an alarm.

In addition, for example, when the robot arm is moved to a position facing the placement structure 54A, the controller 240 can control the robot arm to extend in a direction of the placement structure 54A while supporting the container 4 thereon.

The first moving speed V1 may be set to a speed at which the placement structure 54A (which is located far from the elevator 74 (elevating shaft) in the horizontal direction) can reach the position at which the container 4 can be transferred during a time in which the transfer robot 78 is moved from the position at which the operation of picking up the container 4 from the placement structure 20 of the loading/unloading structure 14 is performed (that is, the position at which the container pick operation ("FOUP PICK OPERATION" in FIG. 8) is performed) to reach the height position of the placement structure 54A (which is predetermined). Thereby, even when a destination (that is, the placement structure 54A) is located far from the elevator 74, it is possible for the transfer robot 78 to reliably transfer the container 4 without waiting at the position at which the container 4 can be transferred.

In addition, the first moving speed V1 may be set to a speed at which the placement structure 54A (which is located farthest from the elevator 74 (elevating shaft) in the horizontal direction) can reach the position at which the container 4 can be transferred during a time in which the transfer robot 78 is moved from the position at which the operation of picking up the container 4 from the placement structure 20 of the loading/unloading structure 14 is performed (that is, the position at which the container pick operation ("FOUP PICK OPERATION" in FIG. 8) is performed) to reach the height position of the placement structure 54A (which is predetermined). Thereby, even when the destination (that is, the placement structure 54A) is located farthest from the elevator 74, it is possible for the transfer robot 78 to reliably transfer the container 4 without waiting at the position at which the container 4 can be transferred.

The first moving speed V1 may be set such that the first moving speed V1 when the shelf plate 54 is not supporting the container 4 is faster than the first moving speed V1 when the shelf plate 54 is supporting the container 4. A speed of the shelf plate 54 is preferably set by taking into consideration an instability of the supporting state of the container 4 when the container 4 is present on the shelf plate 54. However, since the consideration of the instability of the supporting state of the container 4 can be omitted when the container 4 is not present on the shelf plate 54, it is possible to increase the speed of the shelf plate 54, and as a result, it is possible to increase an overall transfer throughput.

The first moving speed V1 may be set such that the first moving speed V1 when the wafer 2 is not loaded (placed) on the container 4 supported by the shelf plate 54 is faster than the first moving speed V1 when the wafer 2 is loaded on the container 4 supported by the shelf plate 54. The speed of the shelf plate 54 is preferably set by taking into consideration a shift of the wafer 2 when the wafer 2 is present in the container 4. However, since the consideration of the shift of the wafer 2 can be omitted when the wafer 2 is not present in the container 4, it is possible to increase the speed of the shelf plate 54, and as a result, it is possible to increase the overall transfer throughput. In addition, when the first moving speed V1 is too fast, the wafer 2 supported in the container 4 may shift. In such a case, there is a concern that the wafer 2 may collide with the wall of the container 4 and that the damage or the peeling of the film formed on the wafer 2 may occur and the particles may be generated in the container 4 due to the peeling.

The first moving speed V1 may be set to a speed at which at least one among the wafers 2 in the containers 4 supported by the shelf plates 54 does not collide with the wall of the container 4. The speed of the shelf plate 54 is preferably set by taking into consideration the shift of the wafer 2 when the wafer 2 is present in the container 4. However, since the consideration of the shift of the wafer 2 can be omitted when the wafer 2 is not present in the container 4, it is possible to increase the speed of the shelf plate 54, and as a result, it is possible to increase the overall transfer throughput.

The first moving speed V1 may be set to a speed at which the container 4 can be maintained being supported by the shelf plate 54. By engaging the concave structure of the container 4 with the pins 54B provided on the shelf plate 54, the container 4 is supported. However, when the first moving speed V1 is too fast, there is a concern that the supporting state of the container 4 may become unstable due to the centrifugal force. Therefore, the first moving speed V1 is set to the speed at which the container 4 can be maintained being stably supported by the shelf plates 54.

The second moving speed V2 may be set to a speed at which the transfer robot 78 can move from a height position of the placement structure 20 of the loading/unloading structure 14 to reach a height position at which the container 4 can be transferred to the placement structure 54A before the placement structure 54A to which the container 4 is to be transferred reaches the position at which the container 4 can be transferred. Thereby, it is possible for the transfer robot 78 to transfer the container 4 to the placement structure 54A without waiting for the transfer robot 78.

The second moving speed V2 may be set to a speed at which the transfer robot 78 can move from the height position of the placement structure 20 of the loading/unloading structure 14 to reach the height position of the placement structure 54A before the placement structure 54A (which is located farthest from the elevator 74 (elevating shaft) in the horizontal direction) reaches the position at which the container 4 can be transferred. Thereby, even when the destination (that is, the placement structure 54A) is located farthest from the elevator 74, Thereby, it is possible for the transfer robot 78 to transfer the container 4 to the placement structure 54A without waiting for the transfer robot 78.

The shelf plates 54 serving as the second container support may be provided in a direction of gravity, and the second moving speed V2 may be set in accordance with a height position of the shelf plate 54 arranged at the highest position. Thereby, even when the destination (that is, the placement structure 54A) is located at the highest position, it is possible for the transfer robot 78 to transfer the container 4 to the placement structure 54A of the shelf plate 54 without waiting for the transfer robot 78. In addition, since the second moving speed V2 may be set in accordance with a height of the destination, it is possible to flexibly change the second moving speed V2 in accordance with a transfer situation, and it is also possible to increase the overall transfer throughput.

The second moving speed V2 may be set such that the second moving speed V2 when the shelf plate 54 is not supporting the container 4 is faster than the second moving speed V2 when the shelf plate 54 is supporting the container 4. The second moving speed V2 (that is, an elevation and lowering speed) of the transfer robot 78 is preferably set by taking into consideration a large shaking of the container 4 and the instability of the supporting state of the container 4 when the container 4 is present. However, since the consideration of the large shaking of the container 4 and the instability of the supporting state of the container 4 can be neglected when the container 4 is not present, it is possible to increase the second moving speed V2, and as a result, it is possible to increase the overall transfer throughput.

The second moving speed V2 may be set such that the second moving speed V2 when the wafer 2 is not loaded (placed) on the container 4 supported by the shelf plate 54 is faster than the second moving speed V2 when the wafer 2 is loaded on the container 4 supported by the shelf plate 54. The second moving speed V2 is preferably set by taking into consideration the shift of the wafer 2 when the wafer 2 is present in the container 4. However, since the consideration of the shift of the wafer 2 can be neglected when the wafer 2 is not present in the container 4, it is possible to increase the second moving speed V2, and as a result, it is possible to increase the overall transfer throughput.

The substrate processing apparatus 10 can be configured such that the transfer robot 78 is elevated at least partially in parallel with a rotation of the shelf plate 54 (which serves as the second container support) provided with the placement structure 54A.

When the transfer robot 78 transfers the container 4 placed thereon to the placement structure 54A (which is predetermined), after confirming that the placement structure 54A predetermined as the destination is in a desired position, the transfer robot 78 extends the robot arm. That is, when the placement structure 54A (which is desired) is not in the desired position (in other words, the transfer position for the container 4), the transfer robot 78 does not extend the robot arm. Thereby, it is possible to prevent the container 4 from being transferred to an incorrect position. As described above, the CR axis motor (not shown) of the support column rotator 52A configured to rotate the rotating shaft 52 of the rotatable shelf 50 is connected to the CR axis encoder (not shown) serving as the sensor configured to detect the rotation direction, the rotation position and the rotation speed of the CR axis motor. Thereby, the controller 240 determines whether the placement structure 54A (which is desired) is in the desired position based on rotation position data from the CR-axis encoder , and enables the robot arm to be extended when it is determined that the placement structure 54A (which is desired) is in the desired position.

In addition, the controller 240 can grasp (determine) the desired position by storing a rotation position of the rotating shaft 52 and rotation position information from the CR axis encoder (not shown) in a storage such as the memory 239c. By confirming the rotation position of the rotating shaft 52 based on the rotation position information from the CR-axis encoder (not shown), the controller 240 can reliably grasp a rotation state of the rotatable shelf 50.

The controller 240 can also function as a determination processor (determination structure) capable of performing various determinations related to an operation of each component constituting the substrate processing apparatus 10. For example, the controller 240 can determine whether the container 4 can be transferred to the placement structure 54A. For example, the controller 240 can detect a presence or absence of the container 4 by installing a laser distance sensor (which can detect whether the container 4 is present on the placement structure 54A at the transfer position for the container 4) at the transfer robot 78. Alternatively, the controller 240 can detect the presence or absence of the container 4 by grasping a position of the placement structure 54A where the container 4 is not placed based on the rotation position information from the CR axis encoder (not shown). By extending the robot arm based on the determination of the controller 240, it is possible to reliably transfer the container 4 to the placement structure 54A.

In addition, a distance (gap) may be provided between the other front end (tip) of the second arm 84 of the transfer robot 78 and an outer peripheral end of the convex structure of the shelf plate 54. Such a distance can be measured by the laser distance sensor.

In addition, the laser distance sensor can also measure a distance between a position of the front end of the second arm 84 and the base provided in the vicinity of the central portion of the shelf plate 54 when the robot arm is extended toward the placement structure 54A, and can also measure a distance between the position of the front end of the second arm 84 and a position of a front end (tip) of the convex structure on an outer periphery of the shelf plate 54.

For example, the distance may be measured after the robot arm is located opposite to the placement structure 54A (which is a transfer target destination of the container 4) and before the container 4 is transferred. By measuring the distance before the container 4 is moved, it is possible to prevent a collision between the second arm 84 and the front end of the convex structure on the outer periphery of the shelf plate 54.

In addition, for example, the distance may be measured before the robot arm faces the shelf plate 54. Thereby, it is possible to prevent the collision between the second arm 84 and the front end of the convex structure on the outer periphery of the shelf plate 54.

The controller 240 (which functions as the determination processor) can determine whether or not the transfer operation for the container 4 is possible based on whether or not another container (among the containers 4) is placed on the placement structure 54A to which the container 4 is to be transferred. By determining whether or not another container is placed on the placement structure 54A to which the container 4 is to be transferred, it is possible to reliably transfer the container 4 to the placement structure 54A. For example, when another container is already present in a position at which the robot arm of the transfer robot 78 is to be extended, the controller 240 can determine that the transfer operation for the container 4 is not possible.

The controller 240 (which functions as the determination processor) can determine whether or not the transfer operation for the container 4 is possible based on information on a distance between the placement structure 54A and the transfer robot 78. For example, the information on the distance between the placement structure 54A and the transfer robot 78 can be obtained by installing the laser distance sensor (which can measure the distance between the placement structure 54A and the transfer robot 78) at the robot arm. For example, when it is determined that the placement structure 54A is not at a position within a pre-set distance (predetermined distance), it is determined that the transfer operation for the container 4 is not possible, and the transfer operation for the container 4 is not performed. However, when it is determined that the placement structure 54A is located at a position within the pre-set distance (predetermined distance), the transfer operation for the container 4 is performed. Thereby, it is possible to transfer the container 4 to a correct position on the placement structure 54A.

The controller 240 (which functions as the determination processor) can determine whether or not the transfer operation for the container 4 is possible based on whether or not the placement structure 54A is at the desired position (that is, the transfer position for the container 4). The controller 240 determines whether or not the placement structure 54A is at the desired position based on the rotation position information from the CR-axis encoder (not shown). Thereby, it is possible to reliably transfer the container 4 to the placement structure 54A. For example, when the placement structure 54A is at a position which the robot arm of the transfer robot 78 cannot be reached, it is determined that the placement structure 54A is not at the desired position, and the robot arm is not extended.

In addition, after a predetermined processing is performed on the wafer 2 in the process chamber 92, it is possible to manufacture the semiconductor device by further performing processes such as a wiring process and a packaging process.

When the controller 240 determines that the transfer operation for the container 4 to the shelf plate 54 to which the container 4 is to be transferred is "not proper" (that is, when an abnormality of the apparatus occurs), the controller 240 can perform the control the transfer robot 78 such that the transfer operation for the container 4 is not performed.

When the placement structure 54A is moved to the position facing the robot arm, the controller 240 can control the robot arm of the transfer robot 78 to be extended toward the placement structure 54A in a state where the hand 86 supports the container 4.

The controller 240 can control the container transfer apparatus 70 such that the robot arm is located at the position facing the container support such as the first container support while the placement structure 54A is being moved.

The controller 240 can predict (estimate) a state (such as deterioration state) of each component by machine learning, and can control each speed mentioned above in accordance with the deterioration state of each component predicted in a manner described above. In addition, instead of or in addition to the machine learning, the controller 240 can also detect the state of each component by a usage time of each component, abnormal sounds and the like.

Subsequently, a rotation speed VR of the rotatable shelf 50 when the container 4 is placed on the shelf plate 54 and when the container 4 is not placed on the shelf plate 54, and when the wafer 2 is present in the container 4 and when the wafer 2 is not present in the container 4, will be described with reference to Table #1.

**[Table #1]**

| | When the container is placed on the shelf plate | | When the container is not placed on the shelf plate |
|---|---|---|---|
| Presence or absence of the wafer | Present | Absent | - |
| Speed | VR1 | VR2 | VR3 |

| | | | |
|---|---|---|---|
| Speed comparison: VR1 < VR2 < VR3 | | | |

That is, the speed VR1 is lower than the speed VR2, and the speed VR2 is lower than the speed VR3. The speed VR1 is a speed at which the wafer 2 and the container 4 can be stably supported (held). The speed VR2 is a speed at which the container 4 can be stably supported (held). Since the wafer 2 is not present in the container 4, an instability of a supporting state of the wafer 2 can be neglected. Since it will suffice as long as the container 4 is stably supported, the speed VR2 may be set higher than the speed VR1. The speed VR3 is a speed higher than the speed VR1 and the speed VR2. Since the container 4 is not placed on the shelf plate 54, the instability of the supporting state of the container 4 and that of the wafer 2 can be neglected. Therefore, the speed higher than the speed VR1 and the speed VR2 can be used as the speed VR3. When a transfer efficiency is to be increased, the speed VR3 may be set to the maximum speed within a range in which the apparatus can be operated. In a manner described above, since the rotation speed of the rotatable shelf 50 may be set appropriately in accordance with each situation, it is possible to flexibly operate the apparatus. As a result, it is possible to improve a throughput of an entirety of the apparatus.

Subsequently, a moving speed VZ of the transfer robot 78 when the transfer robot 78 supports (holds) the container 4 and when the transfer robot 78 does not support (hold) the container 4, and when the wafer 2 is present in the container 4 and when the wafer 2 is not present in the container 4, will be described with reference to Table #2. In Table #2, the moving speed VZ of the transfer robot 78 when the container 4 is moved from the loading/unloading structure 14 to the rotatable shelf 50 or the buffer shelf 30 is shown.

**[Table #2]**

| | When the transfer robot supports the container | | When the transfer robot does not support the container |
|---|---|---|---|
| Presence or absence of the wafer | Present | Absent | - |
| Speed | VZ11 | VZ12 | VZ13 |

| | | | |
|---|---|---|---|
| Speed comparison: VZ11 < VZ12 < VZ13 | | | |

That is, the speed VZ11 is lower than the speed VZ12, and the speed VZ12 is lower than the speed VZ13. The speed VZ11 is a speed at which the wafer 2 and the container 4 can be stably supported (held). The speed VZ12 is a speed at which the container 4 can be stably supported (held). Since the wafer 2 is not present in the container 4, the instability of the supporting state of the wafer 2 can be neglected. Since it will suffice as long as the container 4 is stably supported, the speed VZ12 may be set higher than the speed VZ11. The speed VZ13 is a speed higher than the speed VZ11 and the speed VZ12. Since the container 4 is not placed on the shelf plate 54, the instability of the supporting state of the container 4 and that of the wafer 2 can be neglected. Therefore, the speed higher than the speed VZ11 and the speed VZ12 can be used as the speed VZ13. When the transfer efficiency is to be increased, the speed VZ13 may be set to the maximum speed within a range in which the apparatus can be operated. In a manner described above, since the moving speed VZ of the transfer robot 78 may be set appropriately in accordance with each situation, it is possible to flexibly operate the apparatus. As a result, it is possible to improve the throughput of the entirety of the apparatus.

Subsequently, the moving speed VZ of the transfer robot 78 when the container 4 is moved from the rotatable shelf 50 or the buffer shelf 30 to the container opening/closing apparatus 62 will be described with reference to Table #3.

**[Table #3]**

| | When the transfer robot supports the container | | When the transfer robot does not support the container |
|---|---|---|---|
| Presence or absence of the wafer | Present | Absent | - |
| Speed | VZ21 | VZ22 | VZ23 |

| | | | |
|---|---|---|---|
| Speed comparison: VZ21 < VZ22 < VZ23 | | | |

That is, the speed VZ21 is lower than the speed VZ22, and the speed VZ22 is lower than the speed VZ23. The speed VZ21 is a speed at which the wafer 2 and the container 4 can be stably supported (held). The speed VZ22 is a speed at which the container 4 can be stably supported (held). Since the wafer 2 is not present in the container 4, the instability of the supporting state of the wafer 2 can be neglected. Since it will suffice as long as the container 4 is stably supported, the speed VZ22 may be set higher than the speed VZ21. The speed VZ23 is a speed higher than the speed VZ21 and the speed VZ22. Since the container 4 is not placed on the shelf plate 54, the instability of the supporting state of the container 4 and that of the wafer 2 can be neglected. Therefore, the speed higher than the speed VZ21 and the speed VZ22 can be used as the speed VZ23. When the transfer efficiency is to be increased, the speed VZ23 may be set to the maximum speed within a range in which the apparatus can be operated. In a manner described above, since the moving speed VZ of the transfer robot 78 may be set appropriately in accordance with each situation, it is possible to flexibly operate the apparatus. As a result, it is possible to improve the throughput of the entirety of the apparatus.

Subsequently, the moving speed VZ of the transfer robot 78 when the container 4 is moved from the container opening/closing apparatus 62 to the rotatable shelf 50 or the buffer shelf 30 will be described with reference to Table #4.

**[Table #4]**

| | When the transfer robot supports the container | | When the transfer robot does not support the container |
|---|---|---|---|
| Presence or absence of the wafer | Present | Absent | - |
| Speed | VZ31 | VZ32 | VZ33 |

| | | | |
|---|---|---|---|
| Speed comparison: VZ31 < VZ32 < VZ33 | | | |

That is, the speed VZ31 is lower than the speed VZ32, and the speed VZ32 is lower than the speed VZ33. The speed VZ31 is a speed at which the wafer 2 and the container 4 can be stably supported (held). The speed VZ32 is a speed at which the container 4 can be stably supported (held). Since the wafer 2 is not present in the container 4, the instability of the supporting state of the wafer 2 can be neglected. Since it will suffice as long as the container 4 is stably supported, the speed VZ32 may be set higher than the speed VZ31. The speed VZ33 is a speed higher than the speed VZ31 and the speed VZ32. Since the container 4 is not placed on the shelf plate 54, the instability of the supporting state of the container 4 and that of the wafer 2 can be neglected. Therefore, the speed higher than the speed VZ31 and the speed VZ32 can be used as the speed VZ33. When the transfer efficiency is to be increased, the speed VZ33 may be set to the maximum speed within a range in which the apparatus can be operated. In a manner described above, since the moving speed VZ of the transfer robot 78 may be set appropriately in accordance with each situation, it is possible to flexibly operate the apparatus. As a result, it is possible to improve the throughput of the entirety of the apparatus.

### <Other Embodiments of Present Disclosure>

The technique of the present disclosure is described in detail by way of the embodiments mentioned above. However, the technique of the present disclosure is not limited thereto, and may be modified in various ways without departing from the scope thereof.

For example, according to the embodiments mentioned above, it is possible to form a silicon-containing film such as a silicon nitride film (SiN film) in the process chamber 92. However, the technique of the present disclosure is not limited thereto. For example, the technique of the present disclosure may also be preferably applied when forming, on the wafer 2, a film containing a metal element such as titanium (Ti), zirconium (Zr), hafnium (Hf), tantalum (Ta), niobium (Nb), aluminum (Al), molybdenum (Mo) and tungsten (W), that is, a metal-based film.

That is, the technique of the present disclosure may also be preferably applied when forming a film containing a predetermined element such as a semiconductor element and a metal element. In addition, for example, the technique of the present disclosure may also be preferably applied when performing a process (such as an oxidation process, a diffusion process, an annealing process and an etching process) on the film formed on the wafer 2.

In addition, the technique of the present disclosure is not limited to the semiconductor manufacturing apparatus (which is configured to process a semiconductor wafer) such as the substrate processing apparatus 10 according to the embodiments mentioned above. That is, the technique of the present disclosure may also be applied to another apparatus such as an LCD (Liquid Crystal Display) manufacturing apparatus configured to process a glass substrate.

The present invention may be summarized as follows: It is possible to increase a transfer throughput of the substrate. There is provided a technique that includes: (a) supporting a container capable of accommodating a substrate with a first container support; and (b) controlling a rotating shaft for revolving placement structures arranged in a circumferential direction, an elevating structure for elevating a transfer robot and the transfer robot such that, when transferring a container from the transfer robot to a predetermined placement structure, a second moving speed of the elevating structure at which the transfer robot is elevated is faster than a first moving speed at which the predetermined placement structure is moved to a transfer position where the container is transferable from the transfer robot.

### [Description of Reference Numerals]

| | | | | | |
|---|---|---|---|---|---|
| 2: | Wafer (substrate) | 4: | Container | 10: | Substrate processing apparatus |

## Claims

1. A container transfer method comprising:
(a) supporting a container capable of accommodating a substrate with a first container support; and
(b) controlling: a rotating shaft capable of revolving a plurality of placement structures of a second container support, wherein the plurality of placement structures are capable of supporting the container, and the second container support is arranged above the first container support and provided with the plurality of placement structures arranged in a circumferential direction; an elevating structure capable of elevating and lowering a transfer robot along an elevating shaft; and the transfer robot capable of transferring the container to and from the first container support or the second container support, wherein the rotating shaft, the elevating structure and the transfer robot is controlled such that, when transferring the container from the transfer robot to a predetermined placement structure among the plurality of placement structures, a second moving speed of the elevating structure at which the transfer robot is elevated along the elevating shaft is faster than a first moving speed at which the predetermined placement structure is moved to a transfer position where the container is transferable from the transfer robot.

2. The container transfer method of claim 1, wherein the first moving speed is set so as to enable the predetermined placement structure to reach the transfer position during a time in which the transfer robot is moved from a pick-up position at which the container is picked up from the first container support to reach a height position of the predetermined placement structure.

3. The container transfer method of claim 1 and/or 2, wherein the first moving speed is set so as to enable the predetermined placement structure located farthest from the elevating shaft in a horizontal direction to reach the transfer position during a time in which the transfer robot is moved from a pick-up position at which the container is picked up from the first container support to reach a height position of the predetermined placement structure.

4. The container transfer method of any one or more of claims 1 to 3, wherein the first moving speed is faster when the predetermined placement structure is not supporting the container than when the predetermined placement structure is supporting the container.

5. The container transfer method of any one or more of claims 1 to 4, wherein the first moving speed is set so as to make it possible to maintain a state where the container is supported by the predetermined placement structure.

6. The container transfer method of any one or more of claims 1 to 5, wherein the second moving speed is set so as to enable the transfer robot to move from a height position of the first container support to reach a height position at which the container is transferable to the predetermined placement structure before the predetermined placement structure reaches the transfer position.

7. The container transfer method of any one or more of claims 1 to 6, wherein the second moving speed is set so as to enable the transfer robot to move from a height position of first container support to reach a height position at which the container is transferable to the predetermined placement structure located farthest from the elevating shaft in a horizontal direction before the predetermined placement structure reaches the transfer position.

8. The container transfer method of any one or more of claims 1 to 7, further comprising
one or more second container supports arranged in a direction of gravity,
wherein the second moving speed is set in accordance with a height position of a highest second container support among the second container support and the one or more second container supports.

9. The container transfer method of any one or more of claims 1 to 8, wherein the second moving speed is faster when the transfer robot is not supporting the container than when the transfer robot is supporting the container.

10. The container transfer method of any one or more of claims 1 to 9, wherein, when transferring the container from the transfer robot to the predetermined placement structure, a robot arm of the transfer robot is extended after it is confirmed that the predetermined placement structure to which the container is to be transferred is in a desired position.

11. The container transfer method of any one or more of claims 1 to 10, wherein, when transferring the container from the transfer robot to the predetermined placement structure, it is determined whether the container is transferable to the predetermined placement structure.

12. A substrate processing method comprising:
(a) supporting a container capable of accommodating a substrate with a first container support;
(b) controlling: a rotating shaft capable of revolving a plurality of placement structures of a second container support, wherein the plurality of placement structures are capable of supporting the container, and the second container support is arranged above the first container support and provided with the plurality of placement structures arranged in a circumferential direction; an elevating structure capable of elevating and lowering a transfer robot along an elevating shaft; and the transfer robot capable of transferring the container to and from the first container support or the second container support, wherein the rotating shaft, the elevating structure and the transfer robot is controlled such that, when transferring the container from the transfer robot to a predetermined placement structure among the plurality of placement structures, a second moving speed of the elevating structure at which the transfer robot is elevated along the elevating shaft is faster than a first moving speed at which the predetermined placement structure is moved to a transfer position where the container is transferable from the transfer robot; and
(c) processing the substrate.

13. A method of manufacturing a semiconductor device, comprising:
(a) supporting a container capable of accommodating a substrate with a first container support;
(b) controlling: a rotating shaft capable of revolving a plurality of placement structures of a second container support, wherein the plurality of placement structures are capable of supporting the container, and the second container support is arranged above the first container support and provided with the plurality of placement structures arranged in a circumferential direction; an elevating structure capable of elevating and lowering a transfer robot along an elevating shaft; and the transfer robot capable of transferring the container to and from the first container support or the second container support, wherein the rotating shaft, the elevating structure and the transfer robot is controlled such that, when transferring the container from the transfer robot to a predetermined placement structure among the plurality of placement structures, a second moving speed of the elevating structure at which the transfer robot is elevated along the elevating shaft is faster than a first moving speed at which the predetermined placement structure is moved to a transfer position where the container is transferable from the transfer robot; and
(c) processing the substrate.

14. A program that causes a substrate processing apparatus, by a computer, to perform:
(a) supporting a container capable of accommodating a substrate with a first container support; and
(b) controlling: a rotating shaft capable of revolving a plurality of placement structures of a second container support, wherein the plurality of placement structures are capable of supporting the container, and the second container support is arranged above the first container support and provided with the plurality of placement structures arranged in a circumferential direction; an elevating structure capable of elevating and lowering a transfer robot along an elevating shaft; and the transfer robot capable of transferring the container to and from the first container support or the second container support, wherein the rotating shaft, the elevating structure and the transfer robot is controlled such that, when transferring the container from the transfer robot to a predetermined placement structure among the plurality of placement structures, a second moving speed of the elevating structure at which the transfer robot is elevated along the elevating shaft is faster than a first moving speed at which the predetermined placement structure is moved to a transfer position where the container is transferable from the transfer robot.

15. A substrate processing apparatus comprising:
a first container support capable of supporting a container capable of accommodating a substrate;
a second container support arranged above the first container support and provided with a plurality of placement structures arranged in a circumferential direction and capable of supporting the container;
a rotating shaft capable of revolving the plurality of placement structures;
a transfer robot capable of transferring the container to and from the first container support or the second container support;
an elevating structure capable of elevating and lowering the transfer robot along an elevating shaft; and
a controller configured to be capable of controlling the rotating shaft, the elevating structure and the transfer robot such that, when transferring the container from the transfer robot to a predetermined placement structure among the plurality of placement structures, a second moving speed of the elevating structure at which the transfer robot is elevated is faster than a first moving speed at which the predetermined placement structure is moved to a transfer position where the container is transferable from the transfer robot.
